# EUROPÄISCHE PATENTSCHRIFT

(11) **EP 4 575 521 B1**
(45) Veröffentlichungstag und Bekanntmachung des Hinweises auf die Patenterteilung: **01.07.2026**
(21) Anmeldenummer: 23218613.0
(22) Anmeldetag: 20.12.2023
(51) Int. Cl.: G01R 15/14, F03D 17/00, G01P 5/02, G01W 1/00, H02G 7/00, H02J 13/00, H02J 13/12

(54) **VERFAHREN ZUR ERFASSUNG EINER WINDEIGENSCHAFT AN EINER FREILEITUNG**
METHOD FOR DETECTING A WIND PROPERTY ON AN OVERHEAD LINE
PROCÉDÉ DE DÉTECTION D'UNE PROPRIÉTÉ DE VENT SUR UNE LIGNE AÉRIENNE

(43) Veröffentlichungstag der Anmeldung: 25.06.2025
(73) Patentinhaber: Wobben Properties GmbH, 26607 Aurich (DE)
(72) Erfinder: HOLICKI, Lukas, 64287 Darmstadt (DE)
(74) Vertreter: Eisenführ Speiser

(56) Entgegenhaltungen:
- EP-B1- 3 420 226
- CN-A- 101 027 568
- CN-B- 111 896 769
- US-A1- 2021 215 751
- ALBERDI RAFAEL ET AL: "Overhead Line Ampacity Forecasting With a Focus on Safety", IEEE TRANSACTIONS ON POWER DELIVERY, IEEE SERVICE CENTER, NEW YORK, NY, US, vol. 37, no. 1, 16 February 2021 (2021-02-16), pages 329 - 337, XP011898331, ISSN: 0885-8977, [retrieved on 20220120], DOI: 10.1109/TPWRD.2021.3059804

## Beschreibung

Die Erfindung betrifft ein Verfahren zum Erfassen wenigstens einer Windeigenschaft.

Windeigenschaften, besonders die Windgeschwindigkeit, können für Wettervorhersagen wichtig sein, die für Leistungsprognosen für aus Wind erzeugter Leistung genutzt werden können. Dafür können Wettervorhersagemodelle verwendet werden.

Wettervorhersagemodelle profitieren stark von Beobachtungsdaten, deren flächige Verfügbarkeit nur selten gegeben ist. Wetterprognosen sind eine zentrale Entscheidungsgrundlage für die Direktvermarktung erneuerbarer Energie. Windleistungsprognosen im Kürzest-, Kurz- und Mittelfristbereich werden außerdem mit steigender Penetration der Stromnetze mit Windenergie eine systemkritische Rolle für die sichere Netzbetriebsführung spielen. Kenntnis über die Turbulenzintensität ermöglicht eine Abschätzung der mechanischen Lasten auf Windenergieanlagen, und einen darauf basierenden optimierten Betrieb zur Lebensdauerverlängerung. Außerdem kann eine Windparksteuerung mit Kenntnis präziser Informationen über das Windfeld optimiert werden, z.B. zur Optimierung der jährlichen Energieproduktion (Anual Energy Production, AEP) oder zur Bereitstellung von Regelreserven. Weiterhin können auf Grundlage verteilter Wettervorhersagen neue Standorte erschlossen und bewertet werden.

Für Wetterprognosen können Daten von Wetterstationen, Messmasten und Windenergieanlagen verwendet werden, die alle jeweils eine Messstation bilden können. Solche Messstationen sind aber örtlich ungleich verteilt, sodass in manchen Gebieten Informationen über Windeigenschaften fehlen können.

Die Dokumente US 2021/0215751 A1, ALBERDI RAFAEL ET AL: "Overhead Line Ampacity Forecasting With a Focus on Safety", IEEE TRANSACTIONS ON POWER DELIVERY, IEEE SERVICE CENTER, NEW YORK, NY, US, Bd. 37, Nr. 1, 16. Februar 2021 (2021-02-16), Seiten 329-337, XP011898331, ISSN: 0885-8977, DOI: 10.1109/TPWRD. 2021.3059804, CN 101 027 568 A und CN 111 896 769 B sind Beispiele für die Bestimmung einer Windgeschwindigkeit im Zusammenhang mit Freileitungen.

Der Erfindung liegt somit die Aufgabe zugrunde, wenigstens eines der vorstehend genannten Probleme zu adressieren. Insbesondere soll ein Verfahren vorgeschlagen werden, mit dem möglichst durch eine globale und hochfrequente Messung der Windgeschwindigkeit Wettermodelle und -prognosen verbessert werden können. Zumindest soll zu bisher bekannten Verfahren eine Alternative vorgeschlagen werden.

Erfindungsgemäß wird ein Verfahren nach Anspruch 1 vorgeschlagen. Die Erfindung macht sich zu Nutze und hat dazu erkannt, dass viele Stromnetze Freileitungen nutzen um Energie zu transportieren. Moderne Freileitungen können Sensoren zur Erfassung des Betriebszustandes der Freileitung umfassen. Die Sensormodule können dabei in regelmäßigen Abständen direkt an den Leiterseilen einer Freileitung installiert sein, oder zumindest an Masten der Freileitung. Durch solche Sensoren können Gefahrensituationen erkannt und lokalisiert werden, wie beispielsweise Kurzschlüsse oder Eisbehang. Die Netzbetreiber sind somit in der Lage anhand von sensorisch erfassten Messwerten, die den Zustand der Freileitung wiederspiegeln, die Auslastung der Freileitungen zu optimieren. Sensorisch erfasste Betriebsparameter sind beispielsweise die Leiterseiltemperatur, der Leiterseilstrom sowie die Leiterseilneigung.

Es ist nun eine Erkenntnis der Erfindung, dass aus diesen gemessenen Betriebsparametern an Freileitungen auch Rückschlüsse auf lokale Windeigenschaften getroffen werden können.

Daher wird erfindungsgemäß vorgeschlagen, wenigstens eine Windeigenschaft zu erfassen, wobei zum Erfassen wenigstens eine Freileitung verwendet wird, insbesondere eine Hochspannungsleitung.

Es wird wenigstens ein nichtelektrischer Zustand der Freileitung erfasst. Ein solcher Zustand kann ein Durchhängen der Freileitung, insbesondere ein Maß dafür sein. Ein solcher Zustand kann auch eine Temperatur der Freileitung sein, die auch als Leiterseiltemperatur bezeichnet werden kann.

Weiter hin wird ein Erfassen wenigstens einer elektrischen Größe der Freileitung, vorgeschlagen. Eine solche elektrische Größe kann eine Spannung an der Freileitung sein, z.B. eine Leiter-Leiter-Spannung, oder eine Leiter-Erde-Spannung. Auch wenigstens ein Strom durch einen Strang der Freileitung kommt in Betracht. Eine übertragene oder an einem Ende in die Freileitung eingespeiste elektrische Leistung kommt als erfasste elektrische Größe in Betracht.

Es wird weiter vorgeschlagen, wenigstens eine Windeigenschaft in Abhängigkeit von dem wenigstens einen nichtelektrischen Zustand und der wenigstens einen elektrischen Größe zu bestimmen.

Die Freileitung hängt im Grunde zwischen zwei Strommasten sodass sie einen Durchhang aufweist. Dieser Durchhang ist abhängig von dem Abstand der beiden Masten und der Länge der Freileitung. Je länger die Freileitung ist, umso stärker hängt sie durch. Die Länge der Freileitung hängt von ihrer Temperatur ab. Je nach Material dehnt sich die Freileitung in Abhängigkeit von ihrer Temperatur aus, wird also meist mit zunehmender Temperatur länger. Je wärmer die Freileitung ist, umso länger ist sie und umso stärker hängt sie durch. Ihr Durchhang lässt daher Rückschlüsse auf ihre Temperatur zu.

Die Temperatur hängt von dem Energieeintrag, also besonders durch den Strom durch die Leitung, und der Energieabgabe, also besonders einer Kühlung durch den Wind ab. Durch Sonnenstrahlung kann auch Energie eingetragen werden, das ist jedoch meist vernachlässigbar. Eine Kühlung durch reine Abstrahlung kommt auch in Betracht, ist aber meist vernachlässigbar, oder kann herausgerechnet werden. Die Kühlung kann durch Regen, Luftfeuchtigkeit, Luftdichte und Lufttemperatur beeinflusst werden, was ebenfalls herausgerechnet werden kann. Formeln, die Zusammenhänge genau beschreiben, sind unten noch angegeben.

Vereinfachend hängt die Freileitung bei gleichem Energieeintrag umso stärker durch, je schlechter die Kühlung ist also je schwächer der Wind kühlt. Dadurch kann aus dem Durchhang eine Windgeschwindigkeit quer zur Freileitung abgelesen werden. Die genauen Werte lassen sich berechnen, wenn die konkreten Eigenschaften, insbesondere das Material und die Dicke der Freileitung, bekannt sind. Es kommt aber auch in Betracht, Zusammenhänge durch Vergleichsmessungen aufzunehmen. So können durch einen mobilen Messmast, oder anderes Messmittel wenigstens zwei unterschiedliche Windgeschwindigkeiten und der dabei jeweils aufgetretene Durchhang erfasst werden. Das kann für unterschiedlichen elektrischen Strom durch die Freileitung wiederholt werden.

Ausgehend von solchen aufgenommenen Werten, die in einer Tabelle hinterlegt werden können, kann dann die Windgeschwindigkeit aus dem Durchhang zurückgerechnet werden. Bei anderen Werten des Durchhangs und anderen Werten des Stroms durch die Freileitung kann die Windgeschwindigkeit durch Interpolation oder Extrapolation ermittelt werden.

Der Energieeintrag kann zudem statt aus dem Strom aus der erfassten Spannung und/oder aus der erfassten Leistung ermittelt werden.

Weitere Beispiele, Windeigenschaften zu bestimmen, werden nachfolgend noch angegeben.

Die Freileitung besteht aus einem Material wie beispielsweise Kupfer, Aldrey, Stahl und Aluminium, das eine wärmeabhängige Ausdehnung aufweist. Insbesondere besteht die Freileitung aus einer Kombination mehrerer Materialien bzw. einer Legierung.

Bei der Freileitung handelt es sich vorzugsweise um eine Hochspannungsleitung. Die Erfindung ist jedoch nicht auf Leitungen im Hoch- oder Höchstspannungsnetz beschränkt, sondern kann auch bei Freileitungen im Mittelspannungsnetz oder Niederspannungsnetz Anwendung finden.

Die Freileitung kann einen Sensor zur Messung des Durchhangs der Freileitung und zur Messung der Außentemperatur aufweisen. Der mindestens eine Sensor ist insbesondere an einem Strommast angebracht, es ist jedoch auch möglich, dass der mindestens eine Sensor direkt an einem Leiterseil der Freileitung installiert ist. Bevorzugt sind mehrere Sensoren in einem regelmäßigen Abstand an der Freileitung angebracht. Es können aber auch externe Sensoren verwendet werden, die nicht Teil der Freileitung einschließlich der Strommasten sind, aber bevorzugt werden bereits an den Strommasten vorhandene Sensoren verwendet, sodass kein zusätzlicher apparativer Aufwand erforderlich ist.

Gemäß einem Aspekt wird als wenigstens eine Windeigenschaft eine Windgeschwindigkeit und/oder eine Turbulenzintensität erfasst.

Ein Verfahren zur Bestimmung der lokalen Windgeschwindigkeit aus Mess- und Betriebsdaten dieser Freileitungen ermöglicht eine globale und hochfrequente Messung der Windgeschwindigkeit, mit der Wettermodelle und -prognosen deutlich verbessert werden können.

Die lokale Windgeschwindigkeit an einer Freileitung (bzw. gemittelt über deren Länge) lässt sich aus verfügbaren Betriebs- und Messdaten bestimmen. Bevorzugt werden zu einer Freileitung geeignete Kennlinien bestimmt, die eine Abbildung von z.B. Strom und Temperatur zu Windgeschwindigkeit ermöglichen. Insbesondere erfolgt eine Kalibrierung durch z.B. einen Windmessmast, oder Messdaten aus den Gondelanemometern nahegelegener Windenergieanlagen.

Im Rahmen der Erfindung wurde die Windgeschwindigkeit auch aus einer erfassten Temperatur als nichtelektrischer Zustand bestimmt. Das kann als eine Alternative zur Bestimmung aus dem Durchhang als nichtelektrischer Zustand angesehen werden. Beides kann aber kombiniert werden, besonders, um die Genauigkeit zu verbessern.

Die Turbulenzintensität ist definiert als das Verhältnis der Standardabweichung der Windgeschwindigkeit zum Mittelwert der Windgeschwindigkeit bezogen auf ein Zeitintervall. Das Zeitintervall kann im Bereich von 5 bis 30 Minuten liegen, insbesondere kann es 10 Minuten betragen. Es kommen aber auch andere Zeitbereiche in Betracht. Die Turbulenzintensität ist ein Maß für die Variabilität der Windgeschwindigkeit innerhalb dieser Zeiträume. Sie kann bspw. aus der Berechnung der Windgeschwindigkeit abgeleitet werden. Wird der Verlauf der Windgeschwindigkeit über die Zeit bestimmt, kann die Turbulenzintensität aus diesem zeitlichen Verlauf gemäß der Definition bestimmt werden. Hier wird aber besonders vorgeschlagen, zu berücksichtigen, dass die Erfassung der Windgeschwindigkeit aus der Temperatur und/oder dem Durchhang der Freileitung träger ist als bspw. die Messung mittels LIDAR. Dies kann hier berücksichtigt werden. Eine einfache Berücksichtigung kann über einen Anpassungsfaktor erfolgen, der vorzugsweise vom Mittelwert der Windgeschwindigkeit abhängen.

Gemäß einem Aspekt, wird als der wenigstens eine nichtelektrische Zustand der Freileitung ein Durchhangswert und/oder eine Außentemperatur im Bereich der Freileitung erfasst. Die Verwendung dieser nichtelektrischen Zustände wurde oben schon beispielhaft erläutert. Ergänzend folgen nachfolgend weitere Erläuterungen.

Der Durchhang von Freileitungen ist unter anderem abhängig vom Strom durch die Leitung, der Außentemperatur und damit von der von Strom und Temperatur erzeugten Wärmeausdehnung der Leitung sowie vom Wärmeabtransport *dQ*/*dt,* der wiederum von der Windgeschwindigkeit u abhängt. Mit Kenntnis der elektrischen Größen, die auch als Betriebsdaten der Freileitung bezeichnet werden können und z.B. Strom, bzw. Leistung, die auch als Leistungsfluss bezeichnet werden kann, und Messdaten, besonders Durchhang, und/oder Außentemperatur an der Freileitung, und entsprechender Kalibrierung kann also die Windgeschwindigkeit an einer Freileitung hochfrequent bestimmt werden. Aus diesen Messungen kann auch auf die Turbulenzintensität geschlossen werden, wie oben schon erläutert wurde.

Bei der Kalibrierung werden beispielsweise Daten bezüglich des Durchhangs der Freileitung bei vorbestimmten oder aufgetretenen Stromstärken aufgezeichnet. Wird die Kalibrierung beispielsweise bei Windstille durchgeführt, ist bekannt, welche Auswirkungen die dabei aufgezeichneten Stromstärken auf den Durchhang der Freileitung haben. Ist dieser Zusammenhang für einen Abschnitt der Freileitung bekannt, kann bei vorhandenem Wind, der dazu gemessen werden kann, auf einen Wärmetransport des Windes an der Freileitung geschlossen werden, da der Durchhang der Freileitung bei den aufgezeichneten Stromstärken durch die Kühlung des Windes geringer ausfällt als bei Windstille. Diese Daten können gespeichert und für die Kalibrierung verwendet werden

Alternativ kann eine Kalibrierung auch eine Aufzeichnung des Durchhangs der Freileitung bei möglichst vielen verschiedenen Stromstärken und verschiedenen Windgeschwindigkeiten umfassen. Die Windgeschwindigkeit wird dabei auf eine herkömmliche Weise gemessen. Somit kann für einen gewissen Durchhang der Freileitung insbesondere unter Berücksichtigung weiterer Parameter eine Windgeschwindigkeit aus den Daten der Kalibrierung ermittelt und insbesondere in Tabellen nachgeschaut werden. Zu Werten, die nicht in der Tabelle enthalten sind, kann eine Interpolation oder Extrapolation durchgeführt werden.

Gemäß einem Aspekt, wird als die wenigstens eine elektrische Größe eine über die Freileitung übertragene Leistung, ein über die Freileitung übertragener Strom insbesondere nach Amplitude und Phase, eine über die Freileitung anliegende elektrische Spannung, insbesondere nach Amplitude und Phase, eine Phasenwinkeldifferenz einer Spannung zwischen zwei Referenzpunkten der Freileitung und eine über die Freileitung übertragene Blindleistung erfasst.

Anhand jeder dieser elektrischen Größe kann auf eine durch elektrischen Strom in der Freileitung erzeugte Wärme geschlossen werden.

Bei der Temperatur der Freileitung wirken Strom, der durch die Freileitung fließt und Wind, der auf die Freileitung trifft entgegen, da der Strom durch den internen materialbedingten Widerstand der Freileitung die Freileitung erhitzt während der Wind eine kühlende Wirkung auf die Oberfläche der Freileitung ausübt. Anhand der erfassten elektrischen Größe kann auf eine erzeugte Wärmemenge durch den elektrischen Widerstand in der Freileitung geschlossen werden. Der Strom durch die Leitung erzeugt, physikalisch gesehen, die Wärme. Dazu muss aber nicht unbedingt der Strom unmittelbar gemessen werden. Er kann aus den anderen genannten elektrischen Größen bestimmt werden, oder aus den anderen genannten elektrischen Größen kann ohne ausdrückliche Bestimmung des Stroms auf die erzeugte Wärme geschlossen werden, bzw. sie kann daraus berechnet werden. Dass die Freileitung auch kapazitive und induktive Eigenschaften aufweisen kann, kann es zweckmäßig sein, auch die elektrischen Größen nach Betrag und Phase zu berücksichtigen.

Anhand des Durchhangs der Freileitung kann auf eine mittlere Temperatur in der Freileitung geschlossen werden. Somit ist es möglich auf den kühlenden windbedingten Wärmetransport von der Freileitung an die Umgebungsluft zu schließen. Aus diesem wiederum lassen sich Rückschlüsse auf die Windgeschwindigkeit herleiten.

Gemäß einem Aspekt wird vorgeschlagen, dass eine Windrichtung im Bereich der Freileitung erfasst wird und, eine Windgeschwindigkeit als eine der wenigstens einen Windeigenschaft in Abhängigkeit von dem wenigstens einen nichtelektrischen Zustand der Freileitung und der wenigstens einen elektrischen Größe und zusätzlich in Abhängigkeit von der erfassten Windrichtung bestimmt wird.

Zur Erfassung der Windrichtung können beispielsweise Windfähnchen an den Strommasten oder in der Nähe der Freileitung verwendet werden.

Abhängig von der Windrichtung kann sich der Wärmetransport von der Freileitung an den Wind, ändern. Das lässt sich aus der oben genannten Gleichung ablesen. Anschaulich lässt es sich an einem Extremfall erklären. Wenn nämlich der Wind längs, also parallel zur Freileitung weht, wird die Wärme weniger abtransportiert als wenn der Wind quer zur Freileitung weht

Um es in anderen Worten auszudrücken: Trifft der Wind annährend senkrecht bzw. quer auf die Freileitung, wird Luft, die an der Oberfläche der Freileitung erwärmt wurde direkt, entsprechend der Windrichtung, von der Freileitung wegbewegt. Es gelangt hierdurch mehr frische, noch nicht erwärmte Luft an die Freileitung als in dem Beispiel einer parallelen Windrichtung zum Verlauf der Freileitung.

Zur Berücksichtigung der Windrichtung kann diese ebenfalls für eine Kalibrierung mit aufgenommen werden, insbesondere mit in einer Tabelle als Einflussfaktor hinterlegt werden.

Anhand einer erfassten Windrichtung kann dieser Effekt dann beim Bestimmen der wenigstens einen Windeigenschaft berücksichtigt werden und die Genauigkeit des Verfahrens erhöht werden.

Gemäß einem Aspekt umfasst das Verfahren folgende Schritte: Bestimmen einer Kühlungsleistung des Windes unter Berücksichtigung des wenigstens einen nichtelektrischen Zustands der Freileitung sowie der wenigstens einen elektrischen Größe der Freileitung, und Bestimmen der wenigstens einen Windeigenschaft in Abhängigkeit von der Kühlungsleistung des Windes.

Entsprechend einer der obigen Erläuterungen kann aus dem Durchhang der Freileitung auf eine mittlere Temperatur der Freileitung geschlossen werden. Anhand der erfassten elektrischen Größe des Stroms durch die Freileitung kann ein Betrag für die Erwärmung der Freileitung durch den materialbedingten elektrischen Widerstand der Freileitung bestimmt werden. Somit kann mit entsprechender Kalibrierung eine Kühlleistung des Windes bestimmt werden. Diese Kühlleistung lässt wiederum Rückschlüsse auf die Windgeschwindigkeit des Windes an der Freileitung zu.

Gemäß einem Aspekt erfolgt das Bestimmen der wenigstens einen Windeigenschaft in Abhängigkeit von einem vorbestimmten Temperaturtransportprofil der Freileitung für verschiedene Windgeschwindigkeiten. Das Temperaturtransportprofil gibt einen Zusammenhang zwischen der Lufttemperatur und/oder der Luftfeuchtigkeit und/oder Luftdruck oder Luftdichte im Bereich der Freileitung und der Wärmemenge an, die mit der Luft transportiert werden kann. Es wurde erkannt, dass über die Berücksichtigung eines solchen Temperaturtransportprofils, wenn dazu die aktuelle Außentemperatur erfasst wird, der Wärmeabtransport von der Freileitung genauer berücksichtigt werden kann und dadurch die wenigstens eine Windeigenschaft, insbesondere die Windgeschwindigkeit, genauer erfasst werden kann. Alternativ oder zusätzlich ist eine Berücksichtigung des Temperaturtransportprofils ebenfalls oder besonders vorteilhaft, wenn eine Luftfeuchtigkeit und/oder ein Luftdruck und/oder eine Luftdichte im Bereich der Freileitung erfasst wird, denn es wurde erkannt, dass diese Eigenschaften die Wärmekapazität der Luft beeinflussen können, sodass ihre Berücksichtigung die Genauigkeit des Transportprofils erhöhen kann. Das Temperaturtransportprofil kann durch Vergleichsmessungen erfasst werden.

Gemäß einem Aspekt, umfasst das Verfahren folgenden Schritt: Bestimmen der wenigstens einen Windeigenschaft in Abhängigkeit einer vordefinierten Kennlinie eines Strömungswiderstandskoeffizienten c_{w} der Freileitung.

Zur Definition der Kennlinie eines Strömungswiderstandskoeffizienten c_{w} der Freileitung wird der Strömungswiderstandskoeffizienten c_{w} der Freileitung in Abhängigkeit von einer anderweitig, auf herkömmliche Weise gemessenen Windgeschwindigkeit an der Freileitung aufgenommen. Um eine möglichst hohe Genauigkeit zu erreichen ist es vorteilhaft die Freileitung zwischen jeweils zwei Strommasten zu kalibrieren. Es kann jedoch auch vorteilhaft sein, Freileitungen zwischen mehreren Strommasten gleichzeitig zu kalibrieren. Zur Kalibrierung der Kennlinie können insbesondere Satellitendaten hinzugezogen werden.

Es wurde erkannt, dass der Strömungswiderstandskoeffizient die Windgeschwindigkeit an der Freileitung beeinflusst und damit den Wärmetransport. Durch die Berücksichtigung des Strömungswiderstandskoeffizienten kann daher die Windeigenschaft, besonders die Windgeschwindigkeit genauer erfasst werden. Vorzugsweise wird der Strömungswiderstandskoeffizient in Abhängigkeit von der Windrichtung in Bezug auf die Freileitung bestimmt. Es wurde erkannt, dass der Strömungswiderstandskoeffizient bei quer anströmendem Wind anders, insbesondere größer, sein kann, als bei schräg oder längsanströmendem Wind.

Anhand des Strömungswiderstandskoeffizienten ist es ebenfalls möglich thermische Schichtungen in der die Freileitung umgebenden Luft bei der Bestimmung der Windgeschwindigkeit zu berücksichtigen.

Da die tatsächliche Windgeschwindigkeit von einer Vielzahl von Parametern abhängt, ist es möglich die Bestimmung der Windgeschwindigkeit mit einem erfindungsgemäßen Verfahren anhand von einem oder mehreren dieser Vielzahl von Parametern weiter zu optimieren. Diese Parameter können dabei gemessen, jedoch auch anhand von Modellen aus anderen gemessenen oder simulierten Parametern bestimmt werden.

Gemäß einem Aspekt erfolgt das Bestimmen der wenigstens einen Windeigenschaft in Abhängigkeit von Messdaten einer Windenergieanlage und/oder eines Messmasts eines Windparks in einer Nähe der Freileitung, insbesondere in einer Entfernung von maximal 50km, vorzugsweise maximal 20km zu einem Mittelpunkt der Freileitung, wobei insbesondere das Verfahren in Abhängigkeit von diesen Messdaten kalibriert oder adaptiert wird.

Es wurde erkannt, dass durch nahegelegene Windenergieanlagen, Windparks und/oder Messmasten oftmals gut örtlich verteilt sind und daher oftmals in der Nähe solcher Freileitungen vorhanden sind und Messdaten zu Windeigenschaften aufnehmen, die genutzt werden können. Besonders wurde erkannt, dass solche Messdaten oftmals an der Gondel der Windenergieanlage erfasst werden, oder mit einem Messmast in ähnlicher Höhe. Damit werden die Messdaten in ähnlicher Höhe erfasst, wie die Freileitung hängen und dadurch ist eine gute Vergleichbarkeit gegeben.

Die Messdaten können verwendet werden, um die mittels der Freileitung erfassten Winddaten zu verifizieren, oder sie zu verbessern. Die Messdaten können auch dazu verwendet werden, Erfassen der Winddaten mittels der Freileitung zu Kalibrieren. Zum Erfassen der Winddaten mittels der Freileitung kann ein Freileitungsmodell verwendet werden, das die Zusammenhänge zwischen den nicht elektrischen Zuständen, den elektrischen Größen und den zu erfassenden Windeigenschaften und ggf. weiteren Größen wiedergibt und zur Erfassung der Windeigenschaften verwendet werden kann. Ein solches Freileitungsmodell kann durch die weiteren Daten nahegelegener Windenergieanlagen, Windparks und/oder Messmasten kalibriert bzw. parametriert werden. Es kann auch zusätzlich, besonders später, oder alternativ, verbessert werden. Dazu können die Ergebnisse der abhängig von der Freileitung erfassten Windeigenschaften mit denen verglichen werden, die durch die nahegelegenen Windenergieanlagen, Windparks und/oder Messmasten erfasst wurden. Bei Unterschieden können entsprechende Angleichungen im Freileitungsmodell vorgenommen werden. Je näher dabei der Erfassungspunkt der Daten einer solchen Datenquelle an der Freileitung liegt, desto vorteilhafter wirkt sich dies auf die Genauigkeit der Daten bezüglich der Freileitung aus. Es wurde besonders erkannt, dass nahegelegene Windenergieanlagen, Windparks und/oder Messmasten gute Werte liefern können, und dass selbst bei einer Entfernung von 50km noch gute Vergleichswerte erhältlich sind. Vorzugsweise werden Werte von mehreren, verteilten nahegelegenen Windenergieanlagen, Windparks und/oder Messmasten aufgenommen. Dadurch können Ungenauigkeiten, die sich aus einem Abstand ergeben, ausgeglichen werden.

Gemäß einem Aspekt erfolgt das Bestimmen der wenigstens einen Windeigenschaft in Abhängigkeit von in Voruntersuchungen aufgenommenen Zusammenhängen zwischen Messwerten der Windeigenschaften und dem wenigstens einen nichtelektrischen Zustand der Freileitung und/oder der wenigstens einen elektrischen Größe der Freileitung.

Durch Erhebung solcher Messwerte kann insbesondere eine Kalibrierung durchgeführt werden, insbesondere von dem Freileitungsmodell. Die Messwerte werden bevorzugt zusammen mit Zusammenhängen in Tabellen gespeichert. Anhand dieser aufgenommenen Zusammenhänge kann beispielsweise für einen bestimmten Durchhang der Freileitung insbesondere unter Berücksichtigung weiterer Parameter, eine an diesem Abschnitt der Freileitung herrschende Windgeschwindigkeit aus den Tabellen herausgelesen werden.

Gemäß einem Aspekt wird vorgeschlagen, dass in Abhängigkeit von mehreren lokal verteilten Freileitungen mehrere lokal verteilte Windeigenschaften erfasst werden. Hier wurde besonders erkannt, dass viele Freileitungen lokal verteilt vorhanden sind, wobei als eine Freileitung jeweils ein Abschnitt zwischen zwei Strommasten bezeichnet wird. Dadurch ist es möglich, ein lokal verteiltes Bild über die Windeigenschaften zu erstellen, indem die vorhandenen Gegebenheiten der Freileitungen genutzt werden können.

Vorzugsweise wird in Abhängigkeit von diesen lokal verteilten Windeigenschaften eine Wetterprognose erstellt, insbesondere eine flächig verteilte Wetterprognose. Hier wurde zudem erkannt, dass eine zeitliche Betrachtung der Veränderung der lokal verteilten Windeigenschaften auch eine Veränderung der Windeigenschaften prognostizieren lässt. Bspw. kann erkannt werden, wenn sich ein Bereich mit einer bestimmten, z.B. hohen, Windgeschwindigkeit örtlich verändert, z.B. von Ost nach West zieht. Zusätzlich kann, um bei diesem Beispiel zu bleiben, erkannt werden, ob und wie sich die Windgeschwindigkeit dabei verändert. Daraus kann ihr weiterer Verlauf prognostiziert werden.

Außerdem oder alternativ wird vorgeschlagen, in Abhängigkeit von diesen lokal verteilten Windeigenschaften eine Stromvermarktung zu steuem. Hier liegt besonders die Erkenntnis zu Grunde, dass aus der prognostizierten zeitlichen und örtlichen Veränderung der Windeigenschaft, insbesondere der Windgeschwindigkeit, ableiten lässt, bei welchen Windenergieanlagen und Windparks mit welchen Leistungen aus Wind zu rechnen ist. Daraus kann ein Gesamtleistungsangebot bzw. seine Veränderung abgeleitet werden. Diese kann besonders für die Vermarktung genutzt werden.

Außerdem oder alternativ wird vorgeschlagen, dass in Abhängigkeit von diesen lokal verteilten Windeigenschaften eine Windenergieanlage oder ein Windpark in seiner Steuerung angepasst wird, insbesondere zur Berücksichtigung von Lasten und/oder zur Erhöhung der jährlichen Energieproduktion. Durch die örtlichen Prognosen kann besonders erkannt werden, ob eine Belastungssituation auf eine Windenergieanlage oder einen Windpark zukommt. Darauf kann frühzeitig reagiert werden. Es lässt sich aber auch eine Steuerung hinsichtlich Ertrag verbessern, wenn sich z.B. eine Windenergieanlage auf eine erhöhte Windgeschwindigkeit einstellt und ihre Leistung erhöht, statt wartet, bis sich die Drehzahl des Rotors erhöht, auf die zunächst mit Schutzmechanismen reagiert werden würde. Eine Windenergieanlage kann besser an ihrer Leistungsgrenze geführt werden, wenn bekannt ist, welche Windentwicklung, besonders Entwicklung der Windgeschwindigkeit, aber auch der Windrichtung und Turbulenzintensität zu erwarten ist.

Gemäß einem Aspekt wird vorgeschlagen, dass zum Bestimmen der wenigstens einen Windeigenschaft in Abhängigkeit von dem wenigstens einen nichtelektrischen Zustand und der wenigstens einen elektrischen Größe ein Zustandsbeobachter verwendet wird, insbesondere ein Kalmanfilter. Hier kann besonders ein Zustandsbeobachter vorgesehen sein, der den Durchhang und/oder die Temperatur der Freileitung, also die Leiterseiltemperatur, als Ausgangsgröße hat. Die wenigstens eine elektrische Größe kann eine Eingangsgröße für den Zustandsbeobachter bilden. Der Zustandsbeobachter verwendet dann ein Modell, das die oben genannten Zusammenhänge abbildet und dabei die Windeigenschaft, insbesondere die Windgeschwindigkeit als Zustand des Modells aufweist. Über den Vergleich der genannten Ausgangsgrößen Durchhang und/oder Leiterseiltemperatur mit den entsprechenden gemessenen Werten können die Zustände des Modells abgeglichen werden.

Außerdem oder alternativ wird vorgeschlagen, dass als eine der Windeigenschaft eine Windrichtung erfasst wird. Dazu kann das Modell entsprechend so ausgebildet werden, dass die Windrichtung einen Zustand des Modells bildet.

Außerdem oder alternativ wird vorgeschlagen, dass die Windrichtung in Abhängigkeit von mehreren lokal verteilten Freileitungen erfasst wird. Hier kommt besonders in Betracht, dass die mehreren Freileitungen nicht parallel zueinander verlaufen. Dieselbe Windgeschwindigkeit hat dann durch die unterschiedlichen Anströmrichtungen auf die Freileitungen unterschiedliche Kühlwirkungen zur Folge. Somit kann aus unterschiedlichen Durchhängen und/oder Leitungsseiltemperaturen auf unterschiedliche Anströmrichtungen geschlossen werden, und daraus, unter Berücksichtigung der Ausrichtung der jeweiligen Freileitung, die Windrichtung abgeleitet werden.

Auch hierfür kann ein Zustandsbeobachter verwendet werden. Das Modell des Zustandsbeobachters kann für jede berücksichtigte Freileitung ein Teilmodell aufweisen. Es kann dazu ein Mehrgrößenmodell verwendet werden, das also mehrere Eingangsgrößen und/oder mehrere Ausgangsgrößen aufweist. Die Ausrichtung der Freileitungen kann bei der Verknüpfung der Teilmodelle berücksichtigt werden.

Gemäß einem Aspekt wird vorgeschlagen, dass das Bestimmen der wenigstens einen Windeigenschaft in Abhängigkeit von dem wenigstens einen nichtelektrischen Zustand und der wenigstens einen elektrischen Größe in Abhängigkeit von einer Luftfeuchtigkeit im Bereich der Freileitung erfolgt. Hier wurde erkannt, dass feuchtere Luft mehr Energie transportieren kann, als weniger feuchte Luft, und daher wird vorgeschlagen, diesen Einfluss mit zu berücksichtigen.

Außerdem oder alternativ wird vorgeschlagen, dass das Bestimmen der wenigstens einen Windeigenschaft in Abhängigkeit von dem wenigstens einen nichtelektrischen Zustand und der wenigstens einen elektrischen Größe in Abhängigkeit von einer Luftdichte im Bereich der Freileitung erfolgt. Auch mit höherer Luftdichte kann mehr Energie transportiert werden, was somit berücksichtigt werden kann.

Außerdem oder alternativ wird vorgeschlagen, dass das Bestimmen der wenigstens einen Windeigenschaft in Abhängigkeit von dem wenigstens einen nichtelektrischen Zustand und der wenigstens einen elektrischen Größe in Abhängigkeit von einem Niederschlag im Bereich der Freileitung erfolgt.

Durch seine Berücksichtigung kann eine zusätzliche Wärmeabfuhr von der Freileitung durch Nebel, Regen oder Schnee bei der Bestimmung der Windeigenschaft berücksichtigt werden.

Für jede dieser Größen Luftfeuchtigkeit, Luftdichte und Niederschlag im Bereich der Freileitung kann eine Erfassung, insbesondere Messung, an einem die Freileitung tragendem Strommast erfolgen. Bereiche bis zu einem km Entfernung von der Freileitung können noch als im Bereich der Freileitung bezeichnet werden. Da sich diese Größen örtlich nicht stark bzw. zu schnell ändern, können auch weiter entfernte Messungen verwendet werden. Für den Niederschlag kommt auch in Betracht, ihn aus einer Wettervorhersage zu entnehmen. Ein solcher Niederschlag umfasst neben Regen auch Nebel, Schnee und Hagel. Überdies ist es ebenfalls möglich das Vorhandensein von unterkühltem Niederschlag bei der Bestimmung der Windeigenschaft zu berücksichtigen.

Überdies wird die Berücksichtigung von einem Eisbehang der Freileitung gemäß einem Aspekt vorgeschlagen, denn es wurde erkannt, dass statisches Eis an der Freileitung sowohl die Kühlung des Windes und den Durchhang der Freileitung beeinflusst als auch einen eigenen Kühleffekt auf die Freileitung ausübt.

Im Folgenden wird die vorliegende Erfindung anhand von Ausführungsbeispielen unter Bezugnahme auf die begleitenden Figuren näher erläutert.
- **Fig. 1**: zeigt eine schematische Darstellung einer Hochspannungsleitung,
- **Fig. 2**: zeigt eine schematische Darstellung einer Veränderung eines Durchhangs einer Freileitung,
- **Fig. 3**: zeigt eine weitere schematische Darstellung einer Veränderung eines Durchhangs einer Freileitung.

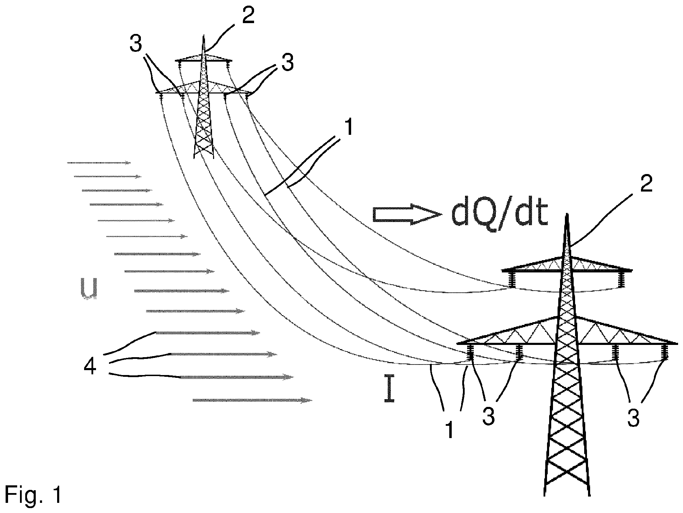

**Figur 1** zeigt in einer schematischen Darstellung sechs Freileitungen 1 geführt von zwei Strommasten 2. In dieser schematischen Darstellung ist jede der Freileitungen 1 über jeweils mindestens einen Isolator 3 mit den Strommasten 2 verbunden. Durch die Freileitungen fließt ein Strom *I*. Eine Windrichtung 4 eines Windes der Windgeschwindigkeit u ist mit mehreren Pfeilen angedeutet. Durch diesen Wind entsteht ein Wärmetransport *dQ*/*dt* von der Oberfläche der Freileitungen 1 in Windrichtung 4, da sich die Windtemperatur von der Temperatur der Freileitungen 1 unterscheidet.

Die nachfolgende Beschreibung weiterer Figuren verwendet für ähnliche oder gleiche Elemente gleiche Bezugszeichen, auch wenn die Elemente nicht identisch sind.

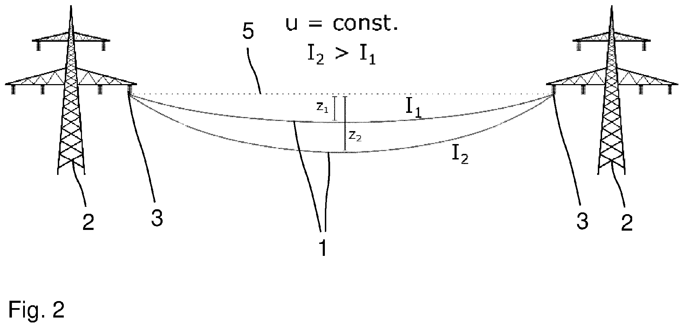

**Figur 2** zeigt in einer schematischen Darstellung eine Freileitung 1 geführt von zwei Strommasten 2 in zwei unterschiedlichen Zuständen. Die Freileitung 1 ist jeweils über einen Isolator 3 mit den Strommasten 2 verbunden. Zwischen den Enden der Isolatoren 3, an denen die Freileitung verbunden ist, zeigt eine gestrichelte verbunden ist, zeigt eine gestrichelte Referenzlinie 5 die Höhe als Referenz an, quasi die Verbindung zwischen den Isolatoren 3, wenn die Freileitung theoretisch nicht durchhinge. In der Figur 2 sind zwei unterschiedliche Durchhänge gezeigt und durch die beiden Abstände *z₁* und *z₂* zur Referenzlinie 5 quantifiziert.

In beiden Zuständen der Freileitung in Figur 2 ist die Windgeschwindigkeit u konstant. Es ergeben sich unterschiedliche Durchhänge dadurch, dass unterschiedlich viel Strom durch die Freileitung fließt. Bei dem Strom I₂, der größer als der Strom I₁ ist, ist der Durchhang daher größer, und daher ist der Abstand z₂ zur Referenzlinie größer als der Abstand z₁.

Mit zunehmender Stromstärke wird durch den elektrischen Widerstand der Freileitung 1 zunehmend Wärme in der Freileitung 1 erzeugt. Somit nimmt, bei gleicher Windgeschwindigkeit *u*, die mittlere Temperatur in der Freileitung 1 mit zunehmender Stromstärke zu. Im zweiten Zustand weist die Freileitung 1 also eine höhere mittlere Temperatur auf, als im ersten Zustand.

Aufgrund der Materialbeschaffenheit der Freileitung dehnt sich die Freileitung mit zunehmender mittlerer Temperatur aus, sodass sich der größere Durchhang bei der größeren Stromstärke, also bei größerem Strom, einstellt.

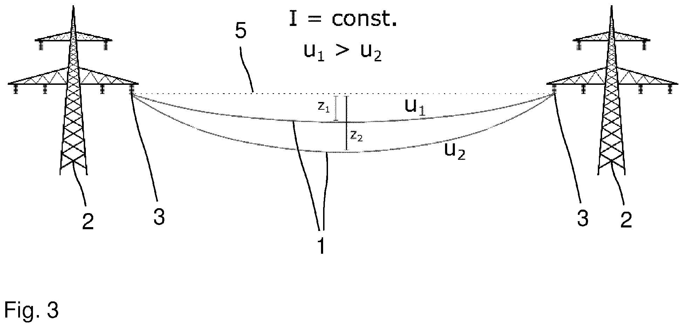

**Figur 3** veranschaulicht, wie aus dem Durchhang die Windgeschwindigkeit u bestimmt werden kann. Hier ist der Strom, bzw. die Stromstärke *I* für die beiden gezeigten Zustände der Freileitung konstant. Die unterschiedlichen Durchhänge, die durch die unterschiedlichen Abstände z₁ und z₂ quantifiziert sind, lassen einen Rückschluss auf die unterschiedliche Windgeschwindigkeit *u* zu. Hier ist aus dem gegenüber dem ersten Abstand z₁ größeren zweiten Abstand z₂ abzulesen, dass die zweite Windgeschwindigkeit u₂ geringer ist als die erste Windgeschwindigkeit u₁.

### Bezugszeichen

- 1: Freileitung
- 2: Strommast
- 3: Isolator
- 4: Windrichtung
- 5: Referenzlinie

Erfindungsgemäß wurde besonders Folgendes erkannt:
Die lokale Windgeschwindigkeit an einer Freileitung, bzw. gemittelt über deren Länge, lässt sich aus verfügbaren Betriebs- und Messdaten bestimmen. Dazu wird gemäß einem Aspekt vorgeschlagen, zu einer Freileitung Kennlinien zu bestimmen, die eine Abbildung von z.B. Strom und Temperatur zu Windgeschwindigkeit ermöglichen. Solche Kennlinien können vorab aufgenommen werden. Vorzugsweise wird für ein solches Verfahren zur Erfassung der Windgeschwindigkeit eine Kalibrierung durch z.B. einen Windmessmast, oder Messdaten aus den Gondelanemometern nahegelegener Windenergieanlagen vorgeschlagen. Der Strom I wirkt hier als Wärmemengenquelle, und die Windgeschwindigkeit u als Wärmesenke.

## Patentansprüche

1. Verfahren zum Bestimmen wenigstens einer Windeigenschaft, wobei zum Erfassen wenigstens eine Freileitung (1) verwendet wird, insbesondere eine Hochspannungsleitung, umfassend:
Erfassen wenigstens eines nichtelektrischen Zustands der Freileitung (1),
Erfassen wenigstens einer elektrischen Größe der Freileitung,
Bestimmen einer Windeigenschaft in Abhängigkeit von
- dem wenigstens einen nichtelektrischen Zustand und
- der wenigstens einen elektrischen Größe, **dadurch gekennzeichnet, dass**
- in Abhängigkeit von mehreren lokal verteilten Freileitungen mehrere lokal verteilte Windeigenschaften erfasst werden.

2. Verfahren zum Bestimmen wenigstens einer Windeigenschaft nach Anspruch 1, **dadurch gekennzeichnet, dass** als die wenigstens eine Windeigenschaft
eine Windgeschwindigkeit (u) und/oder
eine Turbulenzintensität
erfasst wird.

3. Verfahren zum Bestimmen wenigstens einer Windeigenschaft nach Anspruch 1 oder 2, **dadurch gekennzeichnet, dass** als der wenigstens eine nichtelektrische Zustand der Freileitung (1)
ein Durchhangswert und/oder
eine Außentemperatur im Bereich der Freileitung (1) erfasst wird.

4. Verfahren zum Bestimmen wenigstens einer Windeigenschaft nach einem der vorstehenden Ansprüche, **dadurch gekennzeichnet, dass** die wenigstens eine elektrische Größe ausgewählt ist aus der Liste aufweisend
eine über die Freileitung (1) übertragene Leistung,
ein über die Freileitung (1) übertragener Strom (I) insbesondere nach Amplitude und Phase,
eine über die Freileitung (1) anliegende elektrische Spannung, insbesondere nach Amplitude und Phase,
eine Phasenwinkeldifferenz einer Spannung zwischen zwei Referenzpunkten der Freileitung (1) und
eine über die Freileitung (1) übertragene Blindleistung.

5. Verfahren zum Bestimmen wenigstens einer Windeigenschaft nach einem der vorstehenden Ansprüche, **dadurch gekennzeichnet, dass**
eine Windrichtung (4) im Bereich der Freileitung (1) erfasst wird, und
eine Windgeschwindigkeit (u) als eine der wenigstens einen Windeigenschaft in Abhängigkeit von dem wenigstens einen nichtelektrischen Zustand der Freileitung (1) und der wenigstens einen elektrischen Größe und zusätzlich in Abhängigkeit von der erfassten Windrichtung (4) erfasst wird.

6. Verfahren zum Bestimmen wenigstens einer Windeigenschaft nach einem der vorstehenden Ansprüche, **dadurch gekennzeichnet, dass** es umfasst
Bestimmen einer Kühlungsleistung des Windes unter Berücksichtigung des wenigstens einen nichtelektrischen Zustands der Freileitung (1) sowie der wenigstens einen elektrischen Größe der Freileitung (1), und
Bestimmen der wenigstens einen Windeigenschaft in Abhängigkeit von der Kühlungsleistung des Windes.

7. Verfahren zum Bestimmen wenigstens einer Windeigenschaft nach einem der vorstehenden Ansprüche, **dadurch gekennzeichnet, dass**
das Bestimmen der wenigstens einen Windeigenschaft in Abhängigkeit von einem vorbestimmten Temperaturtransportprofil der Freileitung (1) für verschiedene Windgeschwindigkeiten (u) erfolgt.

8. Verfahren zum Bestimmen wenigstens einer Windeigenschaft nach einem der vorstehenden Ansprüche, **dadurch gekennzeichnet, dass**
das Bestimmen der wenigstens einen Windeigenschaft in Abhängigkeit einer vordefinierten Kennlinie eines Strömungswiderstandskoeffizienten c_{w} der Freileitung (1) erfolgt.

9. Verfahren zum Bestimmen wenigstens einer Windeigenschaft nach einem der vorstehenden Ansprüche, **dadurch gekennzeichnet, dass**
das Bestimmen der wenigstens einen Windeigenschaft in Abhängigkeit von Messdaten einer Windenergieanlage und/oder eines Messmasts eines Windparks in einer Nähe der Freileitung (1), insbesondere in einer Entfernung von maximal 50km, vorzugsweise maximal 20km zu einem Mittelpunkt der Freileitung (1) erfolgt, wobei insbesondere das Verfahren in Abhängigkeit von diesen Messdaten Kalibriert oder adaptiert wird.

10. Verfahren zum Bestimmen wenigstens einer Windeigenschaft nach einem der vorstehenden Ansprüche, **dadurch gekennzeichnet, dass**
das Bestimmen der wenigstens einen Windeigenschaft in Abhängigkeit von in Voruntersuchungen aufgenommenen Zusammenhängen zwischen Messwerten der Windeigenschaften und dem wenigstens einen nichtelektrischen Zustand der Freileitung (1) und/oder der wenigstens einen elektrischen Größe der Freileitung (1) erfolgt.

11. Verfahren zum Bestimmen wenigstens einer Windeigenschaft nach einem der vorstehenden Ansprüche, **dadurch gekennzeichnet, dass**
- in Abhängigkeit von den lokal verteilten Windeigenschaften eine Wetterprognose erstellt wird, insbesondere eine flächig verteilte Wetterprognose, und/oder dass
- in Abhängigkeit von den lokal verteilten Windeigenschaften eine Stromvermarktung gesteuert wird, und/oder dass
- in Abhängigkeit von den lokal verteilten Windeigenschaften eine Windenergieanlage oder ein Windpark in seiner Steuerung angepasst wird, insbesondere zur Berücksichtigung von Lasten und/oder zur Erhöhung der jährlichen Energieproduktion.

12. Verfahren zum Bestimmen wenigstens einer Windeigenschaft nach einem der vorstehenden Ansprüche, **dadurch gekennzeichnet, dass**
- zum Bestimmen der wenigstens einen Windeigenschaft in Abhängigkeit von dem wenigstens einen nichtelektrischen Zustand und der wenigstens einen elektrischen Größe ein Zustandsbeobachter verwendet wird, insbesondere ein Kalmanfilter, und/oder
- als eine der Windeigenschaft eine Windrichtung (4) erfasst wird, insbesondere dass
- die Windrichtung (4) in Abhängigkeit von mehreren lokal verteilten Freileitungen erfasst wird.

13. Verfahren zum Bestimmen wenigstens einer Windeigenschaft nach einem der vorstehenden Ansprüche, **dadurch gekennzeichnet, dass**
das Bestimmen der wenigstens einen Windeigenschaft in Abhängigkeit von
einer Luftfeuchtigkeit im Bereich der Freileitung (1), und/oder
einer Luftdichte und/oder ein Luftdruck im Bereich der Freileitung (1), und/oder
einem Niederschlag im Bereich der Freileitung (1), und/oder
einem Eisbehang an der Freileitung (1)
erfolgt.

## Claims

1. Method for determining at least one wind property, wherein
use is made of at least one overhead line (1), in particular a high-voltage line, for the detection, comprising:
detecting at least one non-electrical state of the overhead line (1),
detecting at least one electrical quantity of the overhead line,
determining a wind property on the basis of
- the at least one non-electrical state and
- the at least one electrical quantity, **characterized in that**
- a plurality of locally distributed wind properties are detected on the basis of a plurality of locally distributed overhead lines.

2. Method for determining at least one wind property according to Claim 1, **characterized in that**
the at least one wind property detected is
a wind speed (u) and/or
a turbulence intensity.

3. Method for determining at least one wind property according to Claim 1 or 2, **characterized in that**
the at least one non-electrical state of the overhead line (1) detected is
a sag value and/or
an outside temperature in the region of the overhead line (1).

4. Method for determining at least one wind property according to one of the preceding claims, **characterized in that**
the at least one electrical quantity is selected from the list comprising
a power transmitted over the overhead line (1),
a current (I) transmitted over the overhead line (1), in particular in terms of amplitude and phase,
an electrical voltage present over the overhead line (1), in particular in terms of amplitude and phase,
a phase angle difference of a voltage between two reference points on the overhead line (1) and
a reactive power transmitted over the overhead line (1).

5. Method for determining at least one wind property according to one of the preceding claims, **characterized in that**
a wind direction (4) in the region of the overhead line (1) is detected, and
a wind speed (u) is detected as one of the at least one wind properties on the basis of the at least one non-electrical state of the overhead line (1) and the at least one electrical quantity and additionally on the basis of the detected wind direction (4).

6. Method for determining at least one wind property according to one of the preceding claims, **characterized in that** it comprises
determining a cooling capacity of the wind taking into account the at least one non-electrical state of the overhead line (1) and the at least one electrical quantity of the overhead line (1), and
determining the at least one wind property on the basis of the cooling capacity of the wind.

7. Method for determining at least one wind property according to one of the preceding claims, **characterized in that**
the determination of the at least one wind property is carried out on the basis of a predetermined temperature transport profile of the overhead line (1) for different wind speeds (u).

8. Method for determining at least one wind property according to one of the preceding claims, **characterized in that**
the determination of the at least one wind property is carried out on the basis of a predefined characteristic curve of a flow resistance coefficient c_{w} of the overhead line (1).

9. Method for determining at least one wind property according to one of the preceding claims, **characterized in that**
the determination of the at least one wind property is carried out on the basis of measured data of a wind turbine and/or a measuring mast of a wind farm in the vicinity of the overhead line (1), in particular at a distance of at most 50 km, preferably of at most 20 km, from a centre point of the overhead line (1), wherein, in particular, the method is calibrated or adapted on the basis of these measured data.

10. Method for determining at least one wind property according to one of the preceding claims, **characterized in that**
the determination of the at least one wind property is carried out on the basis of relationships, recorded in preliminary tests, between measured values of the wind properties and the at least one non-electrical state of the overhead line (1) and/or the at least one electrical quantity of the overhead line (1).

11. Method for determining at least one wind property according to one of the preceding claims, **characterized in that**
- a weather forecast, in particular a weather forecast distributed over an area, is made on the basis of the locally distributed wind properties, and/or **in that**
- electricity marketing is controlled on the basis of the locally distributed wind properties, and/or **in that**
- a wind turbine or a wind farm is adjusted in its control, in particular in order to take loads into account and/or to increase the annual energy production, on the basis of the locally distributed wind properties.

12. Method for determining at least one wind property according to one of the preceding claims, **characterized in that**
- in order to determine the at least one wind property on the basis of the at least one non-electrical state and the at least one electrical quantity, use is made of a state observer, in particular a Kalman filter, and/or
- a wind direction (4) is detected as one of the wind properties, in particular **in that**
- the wind direction (4) is detected on the basis of a plurality of locally distributed overhead lines.

13. Method for determining at least one wind property according to one of the preceding claims, **characterized in that**
the determination of the at least one wind property is carried out on the basis of
a humidity in the region of the overhead line (1), and/or an air density and/or an air pressure in the region of the overhead line (1), and/or
a precipitation in the region of the overhead line (1), and/or
an accumulation of ice on the overhead line (1).

## Revendications

1. Procédé de détermination d'au moins une caractéristique de vent, dans lequel au moins une ligne aérienne (1), en particulier une ligne à haute tension, est utilisée pour l'acquisition, comprenant :
l'acquisition d'au moins un état non électrique de la ligne aérienne (1),
l'acquisition d'au moins une grandeur électrique de la ligne aérienne,
la détermination d'une caractéristique de vent en fonction de
- l'au moins un état non électrique et
- l'au moins une grandeur électrique, **caractérisé en ce que**
- en fonction de plusieurs lignes aériennes réparties localement, plusieurs caractéristiques de vent réparties localement sont acquises.

2. Procédé de détermination d'au moins une caractéristique de vent selon la revendication 1,
**caractérisé en ce que**
une vitesse de vent (u) et/ou
une intensité de turbulence
est acquise en tant que l'au moins une caractéristique de vent.

3. Procédé de détermination d'au moins une caractéristique de vent selon la revendication 1 ou 2, **caractérisé en ce que**
une valeur de fléchissement et/ou
une température extérieure dans la zone de la ligne aérienne (1)
est acquise en tant que l'au moins un état non électrique de la ligne aérienne (1).

4. Procédé de détermination d'au moins une caractéristique de vent selon l'une quelconque des revendications précédentes, **caractérisé en ce que** l'au moins une grandeur électrique est sélectionnée dans la liste présentant
une puissance transmise par la ligne aérienne (1),
un courant (I) transmis par la ligne aérienne (1) en particulier selon l'amplitude et la phase,
une tension électrique appliquée par la ligne aérienne (1), en particulier selon l'amplitude et la phase,
une différence d'angle de phase d'une tension entre deux points de référence de la ligne aérienne (1) et
une puissance réactive transmise par la ligne aérienne (1).

5. Procédé de détermination d'au moins une caractéristique de vent selon l'une quelconque des revendications précédentes, **caractérisé en ce que**
une direction de vent (4) est acquise dans la zone de la ligne aérienne (1), et
une vitesse de vent (u) est acquise en tant qu'une de l'au moins une caractéristique de vent en fonction de l'au moins un état non électrique de la ligne aérienne (1) et de l'au moins une grandeur électrique et en plus en fonction de la direction de vent acquise (4).

6. Procédé de détermination d'au moins une caractéristique de vent selon l'une quelconque des revendications précédentes, **caractérisé en ce qu'**il comprend
la détermination d'une puissance de refroidissement du vent en tenant compte de l'au moins un état non électrique de la ligne aérienne (1) ainsi que de l'au moins une taille électrique de la ligne aérienne (1), et
la détermination de l'au moins une caractéristique de vent en fonction de la puissance de refroidissement du vent.

7. Procédé de détermination d'au moins une caractéristique de vent selon l'une quelconque des revendications précédentes, **caractérisé en ce que**
la détermination de l'au moins une caractéristique de vent s'effectue en fonction d'un profil de transport de température prédéterminé de la ligne aérienne (1) pour différentes vitesses de vent (u).

8. Procédé de détermination d'au moins une caractéristique de vent selon l'une quelconque des revendications précédentes, **caractérisé en ce que**
la détermination de l'au moins une caractéristique de vent s'effectue en fonction d'une courbe caractéristique prédéfinie d'un coefficient de résistance à l'écoulement c_{w} de la ligne aérienne (1).

9. Procédé de détermination d'au moins une caractéristique de vent selon l'une quelconque des revendications précédentes, **caractérisé en ce que**
la détermination de l'au moins une caractéristique de vent s'effectue en fonction de données de mesure d'une éolienne et/ou d'un mât de mesure d'un parc éolien à proximité de la ligne aérienne (1), en particulier à une distance maximale de 50 km, de préférence maximale de 20 km d'un point central de la ligne aérienne (1), dans lequel le procédé est en particulier étalonné ou adapté en fonction de ces données de mesure.

10. Procédé de détermination d'au moins une caractéristique de vent selon l'une quelconque des revendications précédentes, **caractérisé en ce que**
la détermination de l'au moins une caractéristique de vent s'effectue en fonction de corrélations enregistrées dans des études préliminaires entre des valeurs de mesure des caractéristiques de vent et l'au moins un état non électrique de la ligne aérienne (1) et/ou l'au moins une grandeur électrique de la ligne aérienne (1).

11. Procédé de détermination d'au moins une caractéristique de vent selon l'une quelconque des revendications précédentes, **caractérisé en ce que**
- une prévision météorologique est établie en fonction des caractéristiques de vent localement réparties, en particulier une prévision météorologique répartie sur toute la surface, et/ou que
- une commercialisation de l'électricité est commandée en fonction des caractéristiques de vent localement réparties, et/ou que
- une éolienne ou un parc éolien est adapté dans sa commande en fonction des caractéristiques de vent localement réparties, en particulier pour prendre en compte les charges et/ou pour augmenter la production annuelle d'énergie.

12. Procédé de détermination d'au moins une caractéristique de vent selon l'une quelconque des revendications précédentes, **caractérisé en ce que**
- pour déterminer l'au moins une caractéristique de vent en fonction de l'au moins un état non électrique et de l'au moins une grandeur électrique, un observateur d'état, en particulier un filtre de Kalman, est utilisé, et/ou
- une direction de vent (4) est acquise en tant qu'une de la caractéristique de vent, en particulier que
- la direction de vent (4) est acquise en fonction de plusieurs lignes aériennes réparties localement.

13. Procédé de détermination d'au moins une caractéristique de vent selon l'une quelconque des revendications précédentes, **caractérisé en ce que**
la détermination de l'au moins une caractéristique de vent s'effectue en fonction
d'une humidité de l'air dans la zone de la ligne aérienne (1), et/ou
d'une densité de l'air et/ou d'une pression de l'air dans la zone de la ligne aérienne (1), et/ou
d'une précipitation dans la zone de la ligne aérienne (1), et/ou d'un rideau de glace sur la ligne aérienne (1).
